(19) Europäisches Patentamt
European Patent Office
Office européen des brevets

(11) Publication number: **0 407 228 A1**

# (12) EUROPEAN PATENT APPLICATION

(21) Application number: **90307469.8**

(22) Date of filing: **09.07.90**

(51) Int. Cl.[5]: **C07F 5/02**, G03C 5/38, G03C 7/02, G03C 1/73, C08F 2/50

(30) Priority: **07.07.89 US 377501**

(43) Date of publication of application: **09.01.91 Bulletin 91/02**

(84) Designated Contracting States: **CH DE FR GB LI**

(71) Applicant: **THE MEAD CORPORATION**
**Mead World Headquarters Courthouse Plaza Northeast**
**Dayton Ohio 45463(US)**

(72) Inventor: **Shanklin, Michael Samuel**
**9805 Mandel Drive**
**Dayton, Ohio 45458(US)**

(74) Representative: **Deans, Michael John Percy et al**
**Lloyd Wise, Tregear & CO. Norman House**
**105-109 Strandand**
**London WC2R OAE(GB)**

## (54) Dye-borate complexes.

(57) Compounds are described of the formula I

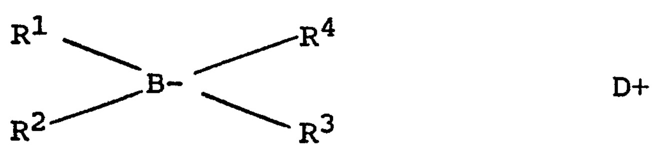

$D^+$ is a cationic dye moiety, $R^1$ is an alkyl group, $R^2$, $R^3$ and $R^4$ are the same or different and selected from aryl, aralkyl and alkaryl. At least one of $R^2$-$R^4$ is halogen-substituted.

EP 0 407 228 A1

## DYE-BORATE COMPLEXES

The present invention relates to a novel class of cationic dye-borate anion complexes.

U.S. Patents 4,772,541 and 4,772,530 to The Mead Corporation disclose a novel class of photoinitiators which are compounds consisting of an ionic photoreducible or photooxidizable dye and a counter ion which absorb light and generate a free radical. The preferred photoinitiators are complexes of a cationic dye and a borate anion. While these photoinitiators are suitable for many applications there is a desire to design photoinitiators which provide higher film speeds.

We have found that the relative film speed achieved with these initiators can be improved by the addition of an onium salt. The onium salt is believed to interact with the dye radical generated upon exposure in a single electron transfer and generate another active radical. One of the difficulties which we have encountered with this onium salt-modified system is the possibility of poor dark stability. The present invention arises from our work seeking to provide dye-borate complexes which can be used in combination with an onium salt and which are dark stable.

The present invention provides a novel class of photoinitiators which can be used in combination with an onium salt to provide higher film speeds. These photoinitiators are represented by the formula (I)

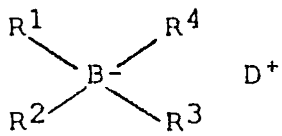

(I)

where $D^+$ is a cationic dye, $R^1$ is an alkyl group and preferably a branched chain alkyl group and $R^2$, $R^3$ and $R^4$ are aryl groups, aralkyl groups or alkaryl groups and at least one (but preferably all) of $R^2$-$R^4$ is a halogen-substituted aryl, alkyaryl, or aralkyl group. Preferably $R^2$-$R^4$ are bromo-substituted or fluoro-substituted phenyl groups and still more preferably 4-fluorophenyl or 4-bromophenyl groups.

Preferably the initiators are represented by the formula (II)

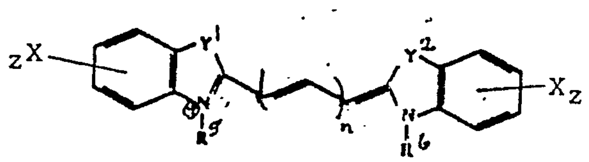
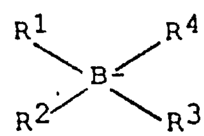

(II)

where $y^1$ and $y^2$ are the same or different and represent an oxygen atom, a sulfur atom, a selenium atom, a vinyl group, $>C(CH_3)_2$, or N-alkyl and may be the same or different; n is 0, 1, 2, or 3; z is 0 to 4; $R^1$, $R^2$, $R^3$ and $R^4$ are defined as in formula (I); $R^5$ and $R^6$ are alkyl groups and preferably an alkyl group having at least 4 and preferably at least 7 carbon atoms; and X is selected based on the desired absorption characteristics of the dye and may be selected from a large number of substituents in a manner known in the art. X may be a hydrogen atom; an electron donating group such as amino, dimethylamino, hydroxy, methoxy, t-butyl, and methyl; or X may be an electron withdrawing group such as phenyl, fluoro, chloro, bromo, iodo, -COOH, -COOR where R is a lower alkyl group, methycarbonyl, trifluoromethyl, cyano, methylsulfonyl, and nitro.

The invention also extends to a photohardenable composition comprising a photoinitiator of formula (I) and a polymerizable compound; and to a photosensitive material comprising a support having a layer of the composition coated thereon.

Methods which can be usefully employed in making examples of our present photoinitiators, photohardenable compositions, and photosensitive materials are described in U.S. Patents 4,772,530 and 4,772,541.

In our present photoinitiators the borate anion preferably includes a single branched chain alkyl group, preferably a secondary alkyl group containing 3 to 10 carbon atoms.

Useful dyes form photoreducible but dark stable complexes with borate anions and can be cationic methine, polymethine, triarylmethane, indoline, thiazine, xanthene, oxazine and acridine dyes. More specifically, the dyes may be cationic cyanine, carbocyanine, hemicyanine, rhodamine and azomethine dyes. The dyes may be substituted as defined above for X, but the dyes should not contain groups which would

neutralize or desensitize the complex or render the complex poorly dark stable. The alkyl groups represented by $R^5$ and $R^6$ may be straight chain, branched chain, or cyclic alkyl groups having 1 to 20 carbon atoms. Preferably at least one of $R^5$ and $R^6$ contains at least 4, more preferably at least 6, and most preferably at least 8 carbon atoms.

With respect to the borate anion, useful examples of alkyl groups include C1-C6 alkyl groups, examples of branched chain alkyl groups are sec-butyl, neopentyl, cyclobutyl, cyclohexyl, etc. The alkyl groups may be substituted, for example, by one or more halogen, cyano, acyloxy, acyl, alkoxy or hydroxy groups.

Representative examples of aryl groups represented by $R^2$-$R^4$ include aryl groups such as phenyl, naphthyl; substituted aryl groups such as anisyl; alkaryl groups such as methylphenyl, dimethylphenyl; aralkyl groups such as benzyl and naphthylmethyl.

As a general rule, useful cationic dye-borate anion complexes must be identified empirically, however, potentially useful cationic dye and borate anion combinations can be identified by reference to the Weller equation (Rehm, D. and Weller, A., Isr. J. Chem. (1970), 8, 259-271), which can be simplified as follows.

$\Delta G = E_{ox} - E_{red} - E_{hv}$ (Eq. 3)

where $\Delta G$ is the change in the Gibbs free energy, $E_{ox}$ is the oxidation potential of the borate anion, $E_{red}$ is the reduction potential of the cationic dye, and $E_{hv}$ is the energy of light used to excite the dye. Useful complexes will have a negative-free energy change. Similarly, the difference between the reduction potential of the dye and the oxidation potential of the borate must be negative for the complex to be dark stable, i .e., $E_{ox} - E_{red} > 0$.

As indicated, Eq. 3 is a simplification and it does not absolutely predict whether a particular complex will provide good results or not. There are a number of other factors which will influence this determination. One such factor is the effect of the monomer on the complex. It is also known that if the Weller equation produces too negative a value, deviations from the equation are possible. Furthermore, the Weller equation only predicts electron transfer, it does not predict whether a particular dye complex is an efficient initiator of polymerization. The equation is a useful first approximation.

Specific examples of cationic dye-borate anion complexes useful in practice of the present invention are:

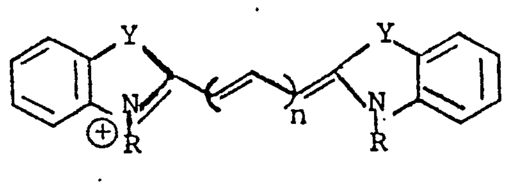

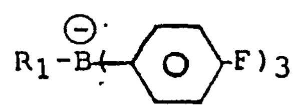

or

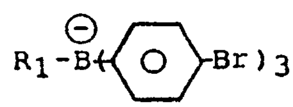

where R and $R^1$ are defined above and $R^1$ is preferably an alkyl group and still more preferably a secondary alkyl group.

The most typical examples of a free radical addition polymerizable or crosslinkable compound useful in practice of the present invention is an ethylenically unsaturated compound and, more specifically, a polyethylenically unsaturated compound. These compounds include both monomers having one or more ethylenically unsaturated groups, such as vinyl or allyl groups, and polymers having terminal or pendant ethylenic unsaturation. Such compounds are well known in the art and include acrylic and methacrylic esters of polyhydric alcohols such as trimethylolpropane, pentaerythritol, and the like; and acrylate or methacrylate terminated epoxy resins, acrylate or methacrylate terminated polyesters, etc. Representative examples include ethylene glycol diacrylate, ethylene glycol dimethacrylate, trimethylol-propane triacrylate (TMPTA), pentaerythritol tetraacrylate, pentaerythritol tetramethacrylate, dipentaerythritol hydroxpentacrylate (DPHPA), hexanediol-1,6-dimethacrylate, and diethyleneglycol dimethacrylate. Higher viscosity monomers such as DPHPA appear to reduce short time reciprocity failure or reversal thereby enabling the use of higher intensity light sources.

The cationic dye-borate anion complex is usually used in an amount up to about 1% by weight based on the weight of the photopolymerizable or crosslinkable species in the photohardenable composition. More typically, the cationic dye-borate anion complex is used in an amount of about 0.2% to 0.5% by weight.

While the cationic dye-borate anion complex can be used alone as the initiator, film speeds tend to be quite low and oxygen inhibition is observed. We have found that it is preferable to use the complex in

combination with an autoxidizer. An autoxidizer is a compound which is capable of consuming oxygen in a free radical chain process.

Representative examples of N,N-dialkylanilines useful in the practice of the present invention as autoxidizers are 4-cyano-N,N-dimethylaniline, 4-acetyl-N,N-dimethylaniline, 4-bromo-N, N-dimethylaniline, ethyl 4-(N,N-dimethylamino) benzoate, 3-chloro-N,N-dimethylaniline, 4-chloro-N,N-dimethylaniline, 3-ethoxy-N,N-dimethylaniline, 4-fluoro-N,N-dimethylaniline, 4-methyl-N,N-dimethylthioanicidine, 4-amino-N,N-dimethylaniline, 3-hydroxy-N,N-dimethylaniline, N,N,N′,N′-tetramethyl-1,4-dianiline, 4-acetamido-N,N-dimethylaniline, etc. Preferred N,N-dialkylanilines are 2,6-diisopropyl-N,N-dimethylaniline, 2,6-diethyl-N,N-dimethylaniline, N,N,2,4,6-pentamethylaniline (PMA) and p-t-butyl-N,N-dimethylaniline.

The autoxidizers are preferably used in concentrations of about 4-5% by weight.

Thiols and dissulfides also appear to enhance film speed although the mechanism is not clear. Particularly preferred thiols are selected from mercaptobenzoxazoles, mercaptotetrazines, mercaptotriazines and mercaptobenzothiazoles. Representative examples include 2-mercaptobenzothiazole, 6-ethoxy-2-mercaptobenzothiazole, 2-mercaptobenzoxazole, 4-methyl-4H-1,2,4-triazole-3-thiol, 2-mercapto-1-methylimidazole, 2-mercapto-5-methylthio-1,3,4-thiadiazole, 5-n -butylthio-2-mercapto-1,3,4-thiadiazole, 4-methoxybenzenethiol, 1-phenyl-1H-tetrazole-5-thiol, 4-phenyl-4H-1,2,4-triazole-3-thiol, 2-mercaptobenzimidazole, pentaerythritol tetrakis (mercaptoacetate), pentaerythritol tetrakis (3-mercaptoproprionate), trimethylolpropane tris(mercaptoacetate), 4-acetamidothiophenol, mercaptosuccinic acid, dodecanethiol, 2-mercaptopyridine, 4-mercaptopyridine, 2-mercapto-3H-quinazoline, and 2-mercaptothiazoline. Disulfides as described in our European Patent Application 90302540.1 (Publication No: EP-A-      ) are also useful.

Our photohardenable compositions may be used in a wide variety of applications. They may be used to prepare photocurable resists, photoadhesives, photocurable coatings, photocurable inks, etc. They may also be microencapsulated and used in the full colour panchromatic imaging system described in U.S. Patent 4,772,541. A preferred method for microencapsulating the composition is described in our European Patent Application No: 88311479.5 (Publication No: EP-A-0319337). A preferred developer material is described in our European Patent Application No: 87307985.9 (Publication No: EP-A-0260129).

Halophenyl borates can be made by the reaction of the Grignard of 1,4-dihalobenzene with dibromoalkylborane. This procedure has been performed using n-butyldibromoborane and the desired borate isolated as the tetramethylammonium salt.

A second approach to triphenylalkyl borates halogen-substituted on one or more of the aromatic rings involves the building of the borate from the trimethoxy borane. Although this procedure involves a multistep process to build up the desired borate, it allows for greater flexibility in designing a borate with the desired combination of solubility and oxidation potential. An advantage of this approach is that boranes which contain one and two p-halophenyl radicals have been made. The resulting borate is metastisized with an appropriate dye as described in U.S. Patents 4,772,530 and 4,772,541.

As indicated at the outset, the present dye complexes are particularly desirable for use in combination with onium salts which enhance the film speeds achieved with the compounds. Examples of useful onium salts are described in copending U.S. Patent Application Ser. No: 07/373852 assigned to the present applicants.

## Claims

1. A compound of the formula I

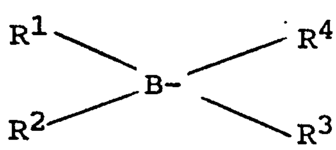

D+ (I)

where $D^+$ is a cationic dye moiety; characterised in that $R^1$ is an alkyl group, and $R^2$, $R^3$ and $R^4$ are the same or different and selected from aryl, aralkyl and alkaryl, at least one of $R^2$-$R^4$ being halogen-substituted.

2. A compound according to Claim 1, further characterised in that said cationic dye moiety is represented by the formula:

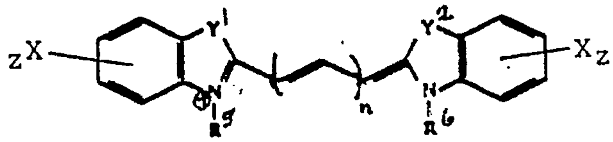

where $y^1$ and $y^2$ are the same or different and represent an oxygen atom, a sulfur atom, a selenium atom, a vinyl group, $>C(CH_3)_2$, or $N-R^7$; z is 0 to 4; n is 0, 1, 2, or 3; $R^7$ is a short chain alkyl group and $R^5$ and $R^6$ represent alkyl groups; and X represents an electron donating group, an electron accepting group or a hydrogen atom.

3. A compound according to Claim 2, further characterised in that X is hydrogen, an alkyl group, an aryl group, an alkoxy group or a halogen atom.

4. A compound according to Claims 2 or 3, further characterised in that said cationic dye is selected from cationic cyanine, carbocyanine and hemicyanine dyes.

5. A compound according to any preceding claim, further characterised in that $R^1$ is a branched chain alkyl group and each of $R^2$, $R^3$ and $R^4$ represent a halogen-substituted aryl group, aralkyl group or alkaryl group.

6. A compound according to Claim 5, further characterised in that $R^2$, $R^3$ and $R^4$ each represent a bromophenyl or fluorophenyl group.

7. A compound according to Claim 6, further characterised in that $R^2$, $R^3$ and $R^4$ each represent 4-bromophenyl or 4-fluorophenyl group.

8. A photohardenable composition characterised in comprising a free radical polymerizable compound and a compound according to any preceding claim.

9. A photohardenable composition according to Claim 8, further characterised in being microencapsulated.

10. A photosensitive material characterised in comprising a support having a layer of a photohardenable composition according to Claims 8 or 9 on the surface thereof.

European Patent Office

# EUROPEAN SEARCH REPORT

Application number

EP 90307469.8

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (Int Cl 5) |
| X<br><br><br><br><br><br>Y | EP - B1 - 0 040 978 (MINNESOTA MINING AND MANUFACTORING CO.)<br>* Claims; page 2, lines 30-53; page 3, last paragraph; page 4, line 1 *<br>-- | 1-7,10<br><br><br><br><br><br>8 | C 07 F 5/02<br>G 03 C 5/38<br>G 03 C 7/02<br>G 03 C 1/73<br>C 08 F 2/50 |
| Y,D | US - A - 4 772 541 (GOTTSCHALK)<br>* Claims; examples *<br>-- | 8 | |
| P,A | EP - A2 - 0 339 841 (MEAD)<br>* Claims 1-5 *<br>---- | 1,8 | |
| | | | TECHNICAL FIELDS SEARCHED (Int Cl 5) |
| | | | C 07 F<br>G 03 C<br>C 08 F |

The present search report has been drawn up for all claims

| Place of search | Date of completion of the search | Examiner |
|---|---|---|
| VIENNA | 13-09-1990 | MARCHART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO Form 1503 03 82